# EUROPEAN PATENT APPLICATION

(11) **EP 4 625 454 A1**
(43) Date of publication of application: **01.10.2025**
(21) Application number: 25163768.2
(22) Date of filing: 14.03.2025
(51) Int. Cl.: H01F 27/28, H01L 23/64, H01L 23/522, H01F 27/32, H01F 19/08

(54) **HIGH-CMTI ISOLATOR LINK DESIGN AND RELATED METHODS**

(30) Priority: 27.03.2024 US 202418618003
(71) Applicant: Analog Devices, Inc., Wilmington, MA 01887 (US)
(72) Inventor: Ha, Dongwan, Wilmington, 01887 (US); Ouyang, Yulun, Wilmington, 01887 (US)
(74) Representative: Horler, Philip John

(57) **Abstract**

Described herein are on-chip isolator devices that can be employed in high-power applications and that are designed to enhance high common-mode transient immunity (CMTI) without sacrificing isolator gain. An isolator device includes two dies. A first die supports an isolation barrier and the second die is barrierless. The second die is barrierless in that it lacks isolation materials that are commonly used to sustain isolation barriers in on-chip isolator devices (e.g., polyimide). To enhance CMTI despite the absence of a further isolation barrier formed on the second die, the second die is provided with a tapped impedance element, an impedance element having a tap that couples the impedance element to a reference potential (e.g., to ground). The secondary side of the isolator of the first die is coupled to the tapped impedance element of the second die, thus creating a discharge path for common-mode transients.

## Description

### RELATED APPLICATIONS

The application claims the benefit of priority from US patent application number 18/618,003, which was filed on 27 March 2024.

### BACKGROUND

### Field

The present application relates to on-chip isolator devices.

### Related Art

Galvanic isolation between circuit components and transmission of data and power across an isolation barrier is often provided for safety and/or data integrity considerations. Galvanic isolation is intended to prevent extraneous signals from inadvertently being processed as status or control information and and/or to protect electronic equipment from shock hazards or to permit the equipment on each side of an isolation barrier to be operated at a different supply voltage.

### BRIEF SUMMARY

Described herein are on-chip isolator devices that can be employed in high-power applications and that are designed to enhance high common-mode transient immunity (CMTI) without sacrificing isolator gain. An isolator device includes two dies. A first die supports an isolation barrier and the second die is barrierless. The second die is barrierless in that it lacks isolation materials that are commonly used to sustain isolation barriers in on-chip isolator devices (e.g., polyimide). To enhance CMTI despite the absence of a further isolation barrier formed on the second die, the second die is provided with a tapped impedance element, an impedance element having a tap that couples the impedance element to a reference potential (e.g., to ground). The secondary side of the isolator of the first die is coupled to the tapped impedance element of the second die, thus creating a discharge path for common-mode transients.

Some embodiments relate to an isolator device, comprising a first die comprising an isolator having a primary side, a secondary side and an isolation barrier formed between the primary side and the secondary side; a second die comprising an impedance element and a tap coupling a portion of the impedance element to a reference potential; and a first electrical connection coupling the secondary side of the isolator of the first die to the impedance element of the second die.

Some embodiments relate to an isolator device, comprising an isolator die forming an isolation barrier between a primary side and a secondary side; a barrierless die comprising a tapped impedance element; and a first electrical connection coupling the secondary side of the isolator die to the tapped impedance element of the barrierless die.

Some embodiments relate to a method for manufacturing an isolator device, comprising obtaining an isolator die forming an isolation barrier between a primary side and a secondary side; obtaining a barrierless die comprising a tapped impedance element; and connecting the isolator die to the barrierless die so that the secondary side of the isolator die is coupled to the tapped impedance element of the barrierless die.

### BRIEF DESCRIPTION OF DRAWINGS

Various aspects and embodiments of the application will be described with reference to the following figures. It should be appreciated that the figures are not necessarily drawn to scale. Items appearing in multiple figures are indicated by the same reference number in all the figures in which they appear.
FIG. 1 is a circuit diagram illustrating an isolator device having a first die forming an isolation barrier and a second die having a tapped impedance element, in accordance with some embodiments.
FIG. 2A is a circuit diagram of an isolator device with a first possible implementation for the impedance element of FIG. 1, in accordance with some embodiments.
FIG. 2B is a circuit diagram of an isolator device with a second possible implementation for the impedance element of FIG. 1, in accordance with some embodiments.
FIG. 2C is a circuit diagram of an isolator device with a third possible implementation for the impedance element of FIG. 1, in accordance with some embodiments.
FIG. 3 is a schematic diagram illustrating an example of the isolator device of FIG. 1, in accordance with some embodiments.
FIG. 4 is a cross sectional view of an example of the first die of FIG. 1, in accordance with some embodiments.
FIG. 5 is a cross sectional view of an example of the second die of FIG. 1, in accordance with some embodiments.

### DETAILED DESCRIPTION

Described herein are on-chip isolator devices that can be employed in high-power applications and that are designed to enhance high common-mode transient immunity (CMTI) without sacrificing isolator gain. CMTI is one of the key characteristics associated with an isolator, especially in the context of high-speed digital communication, in that it quantifies the ability of an isolator to reject common-mode transients. Common-mode transients are voltage spikes or disturbances that occur simultaneously on both the input and the output side of an isolator. These transients can result from various sources such as electromagnetic interference (EMI), electrostatic discharge (ESD), or ground potential differences. CMTI is typically expressed in units of volts per unit of time (e.g., kV/µs) and represents the rate at which the isolator can respond to common-mode transient changes while still maintaining adequate isolation. A higher CMTI value indicates better immunity to common-mode transients. Ensuring a high CMTI is important in digital isolators to prevent signal corruption or damage to sensitive electronic components due to common-mode noise or transients.

The design of an on-chip isolator often involves a trade-off between CMTI and gain. The gain of an isolator, often expressed in decibels (dB), is a measure of the ability of the isolator to prevent unwanted signals or noise from propagating between two connected components or circuits. Gain can be calculated as the ratio of the input power to the output power. In some designs, achieving higher gain may require the use of components that are more sensitive to common mode disturbances, leading to a potential trade-off between CMTI and gain. For example, increasing gain can involve using higher gain amplifier stages, which could also make the isolator more susceptible to common-mode noise.

Unfortunately, conventional approaches for enhancing CMTI in digital isolators are ill-suited for applications requiring high-current operation. One of these applications is in the context of motor drivers, although the technology described herein can be deployed to any other context, and is not limited to motor drivers as other types of loads are also possible. Isolators for motor drivers ensure that the control signals or power supplied to the motor driver are isolated from the rest of the circuitry. This isolation helps prevent electrical noise, ground loops, and other forms of interference from affecting the motor control signals or damaging sensitive electronics in the control system. Isolators should provide immunity to external interference sources such as EMI and ESD, which can otherwise affect the performance of a motor control system. By isolating the motor driver, isolators help shield the control system from external interference, ensuring reliable motor operation.

The inventors have recognized and appreciated that the types of electronic dies that are commonly used to support isolation barriers with large CMTI are not particularly suitable to produce high levels of electric current, needed for high-power applications. This is because the types of materials commonly used to support isolation barriers are not compatible with certain semiconductor processes used to manufacture chips rated for high-current operation. These isolation materials are characterized by a low relative permittivity and a large dielectric strength - characteristics that are ideal for isolators. Polyimide is an example of these materials. Polyimide's low dielectric constant helps minimize capacitance between the primary and secondary sides of the isolator, reducing signal distortion and ensuring high-speed signal transmission. Further, polyimide exhibits high dielectric strength, making it capable of withstanding high voltages without electrical breakdown. This property is crucial for maintaining effective electrical isolation between different regions of an integrated circuit. Lastly, polyimide is compatible with common semiconductor fabrication processes such as photolithography, etching, and deposition. This compatibility facilitates the integration of on-chip isolators into semiconductor devices without requiring significant modifications to existing fabrication processes. However, polyimide is not compatible with all semiconductor fabrication processes. For example, polyimide may not be compatible with semiconductor fabrication processes forming chips on relatively large wafers (e.g., with a diameter than is greater than 8 inches, such as a 10-inch diameter or a 12-inch diameter). In one example, a chip including polyimide may be fabricated on an 8-inch diameter wafer. On the other hand, it may be desirable to fabricate chips designed to provide relatively large output currents (e.g., the level of currents required for motor drivers) on large wafers (e.g., with a diameter than is greater than 8 inches, such as a 10-inch diameter or a 12-inch diameter), to leverage large-volume manufacturing lines. Therefore, common on-chip isolators are ill-suited for use in high-power applications.

According to an aspect of the present disclosure, an isolator device includes a first die and a second die. The first die supports an isolation barrier and the second die is barrierless. The second die is barrierless in that it lacks isolation materials that are commonly used to sustain isolation barriers in on-chip isolator devices (e.g., polyimide or other materials having a dielectric strength greater than 300 kV/mm). Due to its barrierless nature, the second die can be made to produce high levels of electric current (e.g., can be fabricated using semiconductor manufacturing processes used in high-power applications).

To enhance CMTI despite the absence of a further isolation barrier formed on the second die, the second die is provided with a tapped impedance element - an impedance element having a tap that couples a portion (e.g., the mid-point) of the impedance element to a reference potential (e.g., to ground or to another fixed potential). Tapping the impedance element to a reference potential provides a discharge path for currents produced as a result of common mode transients, thereby enhancing the CMTI of the isolator device. The result is a CMTI in excess of 100 kV/µs, 150 kV/µs or even 200 kV/µs, at least in some embodiments. Additionally, enhancing the CMTI without necessarily having to include an additional isolation barrier maintains the gain at a relatively high level. This is because adding barriers generally reduces the gain.

Thus, the first die provides the isolation barrier and the second die provides high CMTI in combination with high-current capabilities. As a result, the types of isolator devices described herein are suitable for use in high-power contexts, including (but not limited to) for use in motor drivers. It should be noted that the isolator devices described herein may include more than two dies in some embodiments, as embodiments of the presented disclosure are not limited to having exactly two dies.

Coupling between the first and second die can be achieved by coupling the secondary side of the isolator that is formed in the first die with the tapped impedance element that is formed on the second die. In this way, voltage spikes or disturbances that occur simultaneously on both the primary side and the secondary side of the isolation barrier can be discharged to ground (or to other fixed potentials). Coupling the secondary side of the isolator to the tapped impedance element may be implemented using electrical connections (e.g., wire bonds). In some embodiments, a pair of electrical connections may be used to couple the dies together, thereby supporting differential signals. The ability to support signals differentially can further improve the CMTI in some embodiments.

It should be noted that the absence of an isolation barrier in the second die presents a drawback relative to implementations where each die has its own barrier. The drawback is that the maximum voltage that the isolator device can sustain without causing electrical breakdown is reduced. In other words, the device provides less isolation.

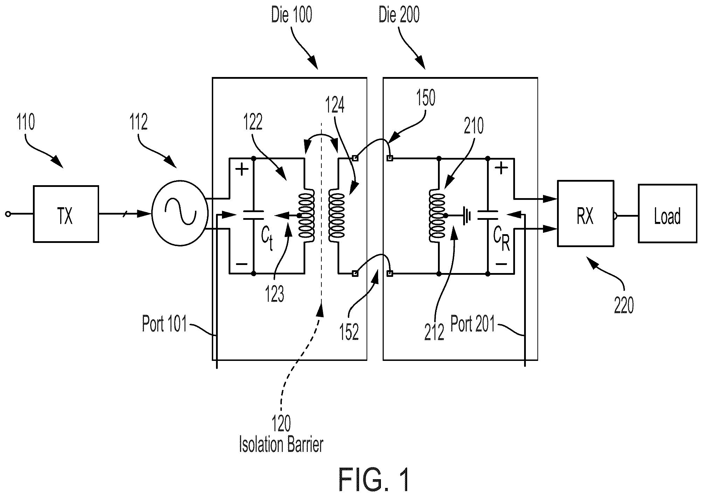

FIG. 1 is a circuit diagram illustrating an example of an isolator device in accordance with some embodiments of the present disclosure. This isolator device includes a die 100 and a die 200. Die 100 defines the input port of the isolator device (port 101) and die 200 defines the output port of the isolator device (port 201). Die 100 includes an isolation barrier 120 between a primary side a secondary side. The primary side is defined by inductor 122 and the secondary side is defined by inductor 124. An isolation material (e.g., polyimide or other materials having a dielectric strength greater than 300 kV/mm) is formed between inductor 122 and inductor 124, thus allowing the isolator to sustain isolation barrier 120. To limit CMTI, inductor 122 is provided with a tap 123, which couples a portion of inductor 122 (e.g., the mid-point) to a reference potential (e.g., the supply voltage V_{DD}). Capacitance C_{T} represents the input capacitance seen from port 101. It should be noted that arrangements other than that illustrated in FIG. 1 may be used to form isolation barrier 120. For example, transformers with isolation materials other than polyimide may be used in some embodiments. In other embodiments, the barrier may be achieved through capacitive isolation instead of inductive isolation. Other types of barriers are also possible.

Die 200 may be barrierless in that it may lack isolation materials commonly used to form isolation barrier in on-chip devices. Due to its barrierless nature, die 200 can be made to produce high levels of electric current (e.g., can be fabricated using semiconductor manufacturing processes used in high-power applications, which are often incompatible with isolation materials).

To enhance CMTI despite the absence of a further isolation barrier on die 200, die 200 is provided with a tapped impedance element 210 - an impedance element having a tap 212 that couples a portion (e.g., the mid-point) of the impedance element to a reference potential (e.g., to ground). Tapping impedance element 210 to a reference potential provides a discharge path for currents produced as a result of common mode transients, thereby enhancing the CMTI of the isolator device. In this example, impedance element 210 is represented as being implemented as an inductor. However, other types of impedance elements are also possible, whether reactive, resistive or capacitive in nature. Other examples of tapped impedance elements are described in detail further below. Capacitance C_{R} represents the output capacitance seen from port 201.

Die 100 is coupled to die 200 via electrical connections 150 and 152, which may be implemented as wire bonds in some embodiments. Having a pair of electrical connections between the dies allows for transmission of signals in a differential fashion. The ability to support signals differentially can further improve the CMTI. Electrical connections 150 and 152 couple (e.g., directly) the secondary side of isolation barrier 120 to tapped impedance element 210.

Transmitter (TX) 110 generates data to be transmitted to receiver (RX) 220 through the isolator device. For example, TX 110 may include a pulse generator. An oscillator 112 may produce waveforms suitable for transmission through isolation barrier 120 based on the data generated by transmitter 110. For example, oscillator 112 may produce square waves or sinusoidal waves (among other examples) encoding the input data. The output of the oscillator may be applied to the primary side of the isolation barrier differentially. Similarly, the output of impedance element 210 may be applied to RX 220 differentially. RX 220 may include circuitry configured to extract the input data generated by TX 110 from the received waveform. RX 220 may in turn drive load 230. Given the high-current nature of die 200, RX 220 may drive high-power loads in some embodiments, including but not limited to gate drivers for motors.

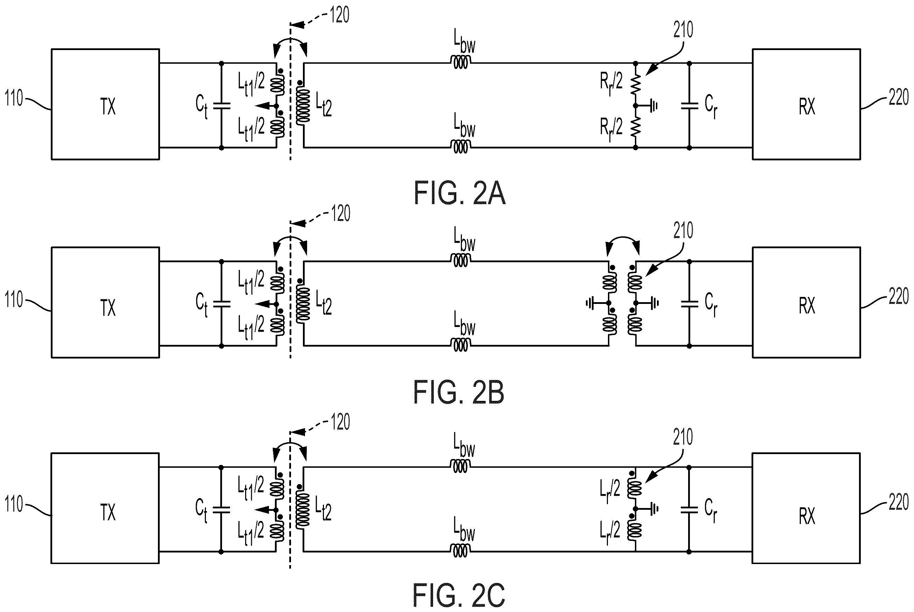

FIGs. 2A, 2B and 2C illustrate three possible implementations of the isolator device of FIG. 1, using different types of impedance elements 210. Inductors L_{bw} represent the inductance of the wire bonds, which may be between 1 nH and 4 nH in some embodiments (e.g., 2 nH).

The impedance element of FIG. 2A includes a pair of resistors having matching resistance Rᵣ/2. Tap 212 couples the mid-point of the impedance element to ground. Being coupled to the mid-point, the resistance of the impedance element is split in two equal halves (although, in some embodiments, the tap may be coupled to a node common to both resistors other than the mid-point).

The impedance element of FIG. 2B includes a transformer, which in turn includes a pair of inductors on the primary side and a pair of inductors on the secondary side. It should be noted that, given the barrierless nature of die 200, the transformer of FIG. 2B should not be viewed as an isolator. This is because the transformer lacks isolation materials between the primary side and the secondary side. A first tap couples the mid-point of the primary side to ground, and a second tap couples the mid-point of the secondary side to ground. Being coupled to the mid-point, the inductance of each side of the impedance element is split in two equal halves (although, in some embodiments, the tap may be coupled to a node common to both inductors other than the mid-point).

The impedance element of FIG. 2C includes a pair of inductors having matching inductance Lᵣ/2. Tap 212 couples the mid-point of the impedance element to ground. Being coupled to the mid-point, the inductance of the impedance element is split in two equal halves (although, in some embodiments, the tap may be coupled to a common node other than the mid-point).

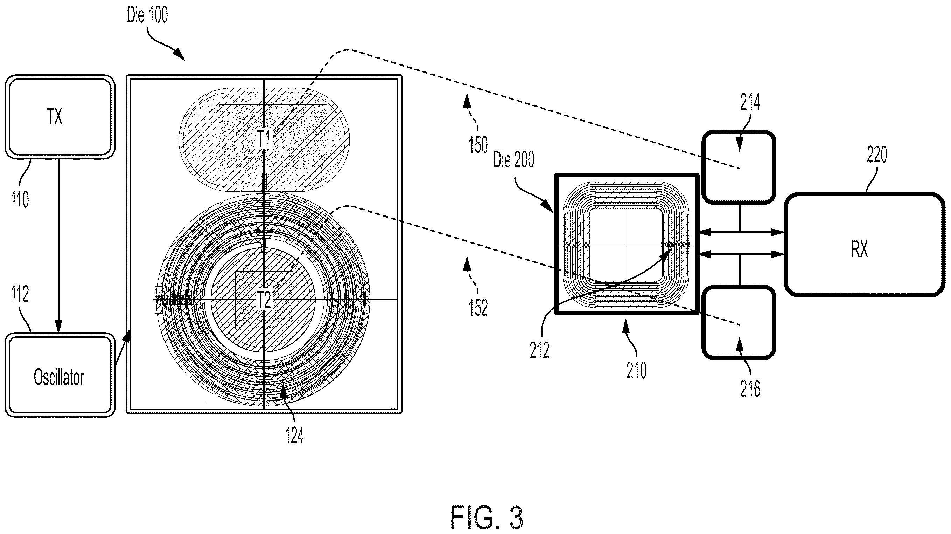

FIG. 3 is a schematic diagram illustrating an example of the isolator device of FIG. 1, in accordance with some embodiments. In this example, impedance element 210 is implemented as a transformer, as discussed for example in connection with FIG. 2B. Both of the dies (100 and 200) are illustrated as top views. Inductors 122 and 124 are shown as including conductive coils stacked on top of each other. An isolation material (not shown in FIG. 3) is disposed between inductor 122 and 124 relative to the vertical direction (the direction perpendicular to the page). On the side of die 100, electrical connection 150 couples to terminal T1 and electrical connection 152 couples to terminal T2. On the side of die 200, electrical connection 150 couples to terminal 214 and electrical connection 152 couples to terminal 216. Electrical connections 150 and 152 are implemented as wire bonds in this example. Impedance element 210 is coupled to terminals 214 and 216, and includes inductors, in the shape of coils, stacked on top of each other and forming a barrierless transformer.

As discussed above, die 100 and die 200 may be made using different semiconductor manufacturing processes. Die 100 may be made using a process compatible with isolation materials. On the other hand, die 200 may be made using a process not compatible with isolation materials, allowing die 200 to be made to produce large output electric. As a result, die 200 may be rated to provide larger electric currents than die 100.

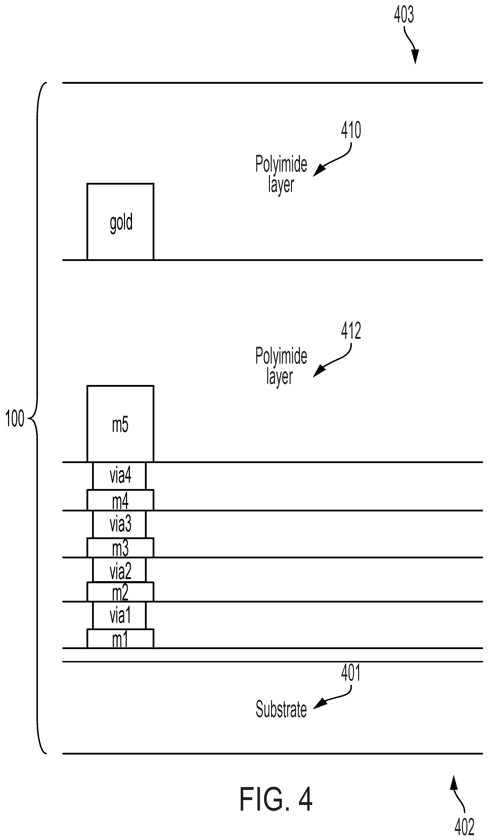

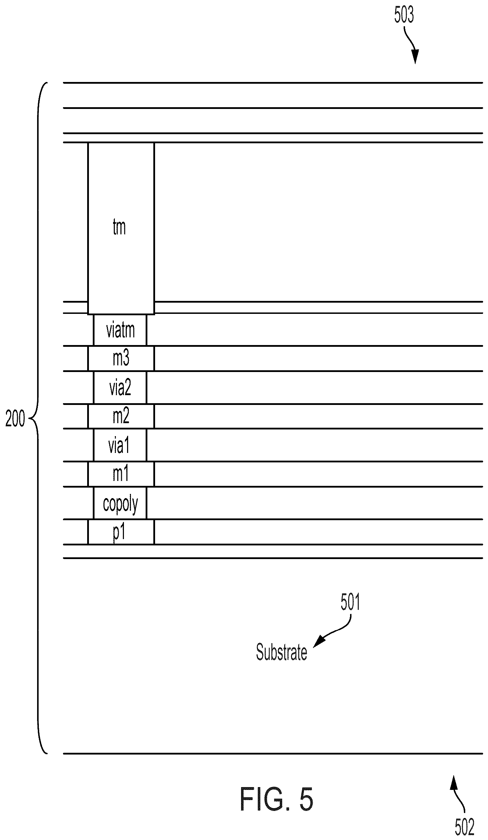

FIG. 4 is a cross sectional view of an example of die 100 and FIG. 5 is a cross sectional view of an example of die 200, in accordance with some embodiments. As can be appreciated from a comparison between FIG. 4 and FIG. 5, because the dies are fabricated using different manufacturing processes, they have different cross sectional layer arrangements. In the example of FIG. 4, die 100 is defined between bottom surface 402 and top surface 403. Substrate 401 is adjacent to bottom surface 402. Die 100 further includes a pair of polyimide layers (410 and 412), which can be used to define one or more isolation barriers. A series of alternating layers are defined between substrate 401 and polyimide layer 412. Those layers include metal contacts (m1, m2, m3, m4 and m5) alternating with conductive vias (vial, via 2, via3 and via4). A gold contact is defined through part of polyimide layer 410.

In the example of FIG. 5, die 200 is defined between bottom surface 502 and top surface 503. Substrate 501 is adjacent to bottom surface 502. A series of alternating layers are defined between substrate 501 and top surface 503. As in FIG. 4, metal contacts alternate with conductive vias. The stack further includes a polysilicon layer ("copoly"). Overall, the cross sectional layer arrangement of die 200 leads to a higher current rating relative to die 100. Notably, die 200 lacks polyimide layers or other layers made of isolation materials that could otherwise sustain an isolation barrier, if positioned between the inductors.

Accordingly, the cross sectional layer arrangements of die 100 may differ from the cross sectional layer arrangement of die 200 in one or more aspects. In one aspect, die 100 includes polyimide while die 200 does not. In another aspect, the overall thickness of die 100 differs from the overall thickness of die 200. In another aspect, the thickness of substrate 401 differs from (e.g., is smaller than) the thickness of substrate 501. In another aspect, the number of alternating layers present in die 100 differs from the number of alternating layers present in die 200. In another aspect, the thickness of some (or all) of the alternating layers present in die 100 differs from the thickness of the corresponding layers present in die 200. It should be noted that not all embodiments are limited to dies that are different from one another in all the aspects enumerated above. In some embodiments, the dies differ only in a subset of the aspects enumerated above.

Some embodiments relate to a method for manufacturing an isolator device. The method may involve obtaining an isolator die (e.g., die 100) forming an isolation barrier (e.g., 120) between a primary side and a secondary side and obtaining a barrierless die (e.g., die 200) comprising a tapped impedance element (e.g., 210). The method may further involve connecting the isolator die to the barrierless die so that the secondary side of the isolator die is coupled to the tapped impedance element of the barrierless die.

In some embodiments, obtaining the isolator die involves fabricating the isolator die using a first manufacturing process and obtaining the barrierless die involves fabricating the barrierless die using a second manufacturing process different from the first manufacturing process. The result is that the cross sectional layer arrangement of the isolator die differs from the cross sectional layer arrangement of the barrierless die in one or more aspects. For example, the first manufacturing process may involve formation of polyimide layers and the second manufacturing process may lack formation of polyimide layers. In some embodiments, connecting the isolator die to the barrierless die involves wire bonding the isolator die to the barrierless die.

### ASPECTS OF THE DISCLOSURE

Non-Limiting aspects of the disclosure are set out in the following numbered claused.
1. An isolator device, comprising:
   a first die comprising an isolator having a primary side, a secondary side and an isolation barrier formed between the primary side and the secondary side;
   a second die comprising an impedance element and a tap coupling a portion of the impedance element to a reference potential; and
   a first electrical connection coupling the secondary side of the isolator of the first die to the impedance element of the second die.
2. The isolator device of clause 1, further comprising a second electrical connection further coupling the secondary side of the isolator of the first die to the impedance element of the second die, wherein the first and second electrical connections are configured to support differential signals.
3. The isolator device of clause 2, wherein the first and second electrical connections include bond wires.
4. The isolator device of any preceding clause, wherein the first die and the second die have different cross sectional layer arrangements.
5. The isolator device of clause 4, wherein the first die comprises an isolation material and the second die lacks isolation materials.
6. The isolator device of clause 4 or clause 5, wherein the first die comprises polyimide and the second die lacks polyimide.
7. The isolator device of any of clauses 4 to 6, wherein the second die is manufactured using a 12-inch wafer and the first die is manufactured using a 8-inch wafer.
8. The isolator device of any of clauses 4 to 7, wherein the second die is rated to provide larger electric currents than the first die.
9. The isolator device of any preceding clause, wherein at least one of the following applies:
   the impedance element comprises a first inductor and a second inductor, wherein the first and second inductors are coupled to a common node, and wherein the tap couples the common node to the reference potential.
10. The isolator device of any preceding clause, wherein the impedance element comprises a barrierless transformer having a primary side and a second side, wherein the tap couples the secondary side of the barrierless transformer to the reference potential.
11. An isolator device, comprising:
   an isolator die forming an isolation barrier between a primary side and a secondary side;
   a barrierless die comprising a tapped impedance element; and
   a first electrical connection coupling the secondary side of the isolator die to the tapped impedance element of the barrierless die.
12. The isolator device of clause 11, further comprising a second electrical connection further coupling the secondary side of the isolator die to the tapped impedance element of the barrierless die, wherein the first and second electrical connections are configured to support differential signals.
13. The isolator device of clause 11 or clause 12, wherein the isolator die and the barrierless die have different cross sectional layer arrangements.
14. The isolator device of clause 13, wherein the isolator die comprises polyimide and the barrierless die lacks polyimide.
15. The isolator device of clause 13 or clause 14, wherein the barrierless die and the isolator die have different current ratings.
16. A method for manufacturing an isolator device, comprising:
   obtaining an isolator die forming an isolation barrier between a primary side and a secondary side;
   obtaining a barrierless die comprising a tapped impedance element; and
   connecting the isolator die to the barrierless die so that the secondary side of the isolator die is coupled to the tapped impedance element of the barrierless die.
17. The method of clause 16, wherein:
   obtaining the isolator die comprises fabricating the isolator die using a first manufacturing process, and
   obtaining the barrierless die comprises fabricating the barrierless die using a second manufacturing process different from the first manufacturing process.
18. The method of clause 17, wherein the first manufacturing process comprises formation of polyimide layers and the second manufacturing process lacks formation of polyimide layers.
19. The method of any of clauses 16 to 18, wherein connecting the isolator die to the barrierless die comprises wire bonding the isolator die to the barrierless die.
20. The method of any of clauses 16 to 19, wherein the barrierless die and the isolator die have different current ratings.

## Claims

1. An isolator device, comprising:
a first die comprising an isolator having a primary side, a secondary side and an isolation barrier formed between the primary side and the secondary side;
a second die comprising an impedance element and a tap coupling a portion of the impedance element to a reference potential; and
a first electrical connection coupling the secondary side of the isolator of the first die to the impedance element of the second die.

2. The isolator device of claim 1, further comprising a second electrical connection further coupling the secondary side of the isolator of the first die to the impedance element of the second die, wherein the first and second electrical connections are configured to support differential signals.

3. The isolator device of claim 2, wherein the first and second electrical connections include bond wires.

4. The isolator device of any preceding claim, wherein the first die and the second die have different cross sectional layer arrangements.

5. The isolator device of claim 4, wherein the first die comprises an isolation material and the second die lacks isolation materials.

6. The isolator device of claim 4 or claim 5, wherein the first die comprises polyimide and the second die lacks polyimide.

7. The isolator device of any of claims 4 to 6, wherein the second die is manufactured using a 12-inch wafer and the first die is manufactured using a 8-inch wafer.

8. The isolator device of any of claims 4 to 7, wherein the second die is rated to provide larger electric currents than the first die.

9. The isolator device of any preceding claim, wherein at least one of the following applies: the impedance element comprises a first inductor and a second inductor, wherein the first and second inductors are coupled to a common node, and wherein the tap couples the common node to the reference potential.

10. The isolator device of any preceding claim, wherein the impedance element comprises a barrierless transformer having a primary side and a second side, wherein the tap couples the secondary side of the barrierless transformer to the reference potential.

11. A method for manufacturing an isolator device, comprising:
obtaining an isolator die forming an isolation barrier between a primary side and a secondary side;
obtaining a barrierless die comprising a tapped impedance element; and
connecting the isolator die to the barrierless die so that the secondary side of the isolator die is coupled to the tapped impedance element of the barrierless die.

12. The method of claim 11, wherein:
obtaining the isolator die comprises fabricating the isolator die using a first manufacturing process, and
obtaining the barrierless die comprises fabricating the barrierless die using a second manufacturing process different from the first manufacturing process.

13. The method of claim 12, wherein the first manufacturing process comprises formation of polyimide layers and the second manufacturing process lacks formation of polyimide layers.

14. The method of any of claims 11 to 13, wherein connecting the isolator die to the barrierless die comprises wire bonding the isolator die to the barrierless die.

15. The method of any of claims 11 to 14, wherein the barrierless die and the isolator die have different current ratings.
